(19) Europäisches Patentamt
European Patent Office
Office européen des brevets

(11) EP 0 511 819 B1

(12) **EUROPEAN PATENT SPECIFICATION**

(45) Date of publication and mention
of the grant of the patent:
**13.03.1996  Bulletin 1996/11**

(51) Int Cl.6: **G05F 1/56**, H02M 3/155,
H03K 17/60

(21) Application number: 92303805.3

(22) Date of filing: **28.04.1992**

(54) **Variable power source circuit**

Schaltung zur variablen Energieversorgung

Circuit pour alimentation en énergie variable

(84) Designated Contracting States:
**DE GB SE**

(30) Priority: **30.04.1991  KR 693991**

(43) Date of publication of application:
**04.11.1992  Bulletin 1992/45**

(73) Proprietor: **SAMSUNG ELECTRONICS CO., LTD.**
**Suwon-City, Kyounggi-Do 441-370 (KR)**

(72) Inventor: **Maeng, Jeong-Jae**
**Seoul (KR)**

(74) Representative: **Stanley, David William et al**
**APPLEYARD LEES**
**15 Clare Road**
**Halifax West Yorkshire HX1 2HY (GB)**

(56) References cited:
**EP-A- 0 196 680**        **DD-A- 245 092**
**GB-A- 2 062 373**        **US-A- 3 638 103**
**US-A- 4 323 839**

## Description

The present invention relates to circuits for selectively producing a power source in a power circuit.

In all apparatuses using a power source, the role of the power source is very important. Most power circuits provide a voltage-regulated output, but in some cases, a power source voltage should be selectively provided among two or more voltages. For example, in Europe as of 1990, a LNB (Low Noise Block-down converter) which selects satellite broadcasting polarization of vertical or horizontal polarization with two different voltages is commercially available, and a power source for this is provided from a satellite broadcasting receiver body.

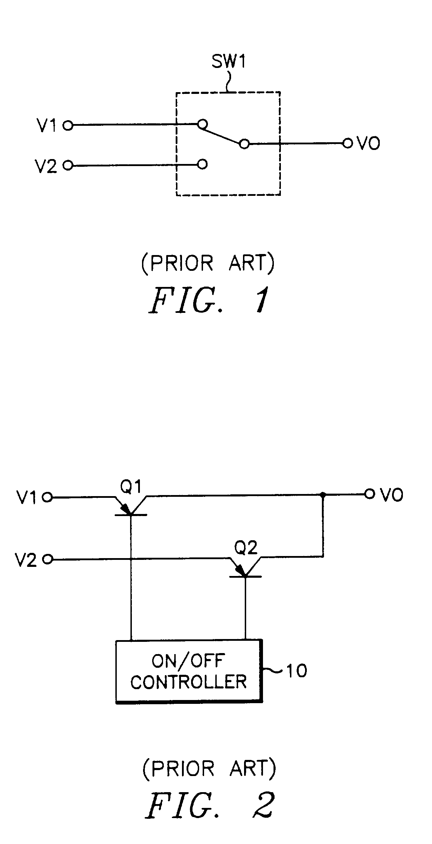

Figures 1 and 2 of the accompanying diagrammatic drawings show conventional power source output circuits. As shown in Figure 1, in order to produce selectively either a first voltage V1 or second voltage V2, a relay or switch SW1 is used. However, high speed operation is difficult due to the mechanical switching, high power consumption is required during the switching operation, and it is difficult to suppress noise caused by electric or magnetic field effects during the switching operation. Furthermore, two supply voltages V1 and V2 are required, and the two supply voltages V1 and V2 must have direct current components without alternating current components. In Figure 2, an on/off control circuit 10 controls transistors Q1 and Q2 connected to first and second supply voltages V1 and V2, respectively so that any one of two transistors Q1 and Q2 can be turned on. Thus, either first voltage V1 or second supply voltage V2 is selected. While the method using transistors has advantages of high speed operation, low power consumption and low noise relative to the mechanical switching method, two power sources are still required and the power sources must have direct current components without alternating current.

EP-A-0196 680 discloses a switching regulator comprising a switching transistor for converting a dc input into a pulsed dc voltage and a transistor connected to said switching transistor and further connected to a feedback circuit for positive feedback of said pulsed dc voltage to the base of said transistor, for causing a driving current to flow through said switching transistor. The apparatus of EP-A-0196680 comprises:

A variable power source comprising: variable voltage regulating means for generating voltage-regulated outputs; reference voltage generating means connected to said variable voltage regulating means.

Preferred embodiments of the present invention aim to provide a circuit for selectively producing any one of a plurality of power sources by changing a reference voltage determined by a zener diode.

A variable power source comprising:

variable voltage regulating means for generating voltage-regulated outputs;

reference voltage generating means connected to said variable voltage regulating means;

characterised in that the level of the voltage-regulated outputs of the variable voltage regulating means is variable in response to a reference voltage applied thereto;

said reference voltage generating means connected to said variable voltage regulating means is for generating said reference voltage; and

switching means connected to said reference voltage generating means for controlling the level of said reference voltage in response to a controlled signal.

Preferably, said switching means is an active switching element responding to said control signal.
Preferably, said active switching element comprises a bipolar transistor.
Preferably, bias means provides a bias voltage to said active switching element.
Preferably, said reference voltage generating means comprises a zener diode.
Preferably, said switching means is connected in parallel with said reference voltage generating means.
Such a circuit may further comprise:

a plurality of said reference voltage generating means connected in series with each other; and

a plurality of said switching means each connected in parallel with a corresponding one of said reference voltage generating means.

Alternatively, such a circuit may further comprise:

a plurality of said reference voltage generating means being connected in parallel to each other; and

a plurality of said switching means each connected in series with a corresponding one of said reference voltage generating means.

Preferably, said variable voltage regulating means comprises:

a control transistor for generating said voltage-regulated outputs, a base of said control transistor being connected to said reference voltage generating means; and

first resistor means being connected between a collector and base of said control transistor, for providing a bias voltage to said control transistor.

Such a circuit may further comprise second resistor means being connected as a load resistor to an emitter of said control transistor.

In a particular embodiment of the present invention, a first capacitor is connected to attenuate the ripple of an input power source. A voltage regulating generator generates voltage-regulated outputs with respect to the input power source having the attenuated ripple. A second capacitor reduces the ripple of an output signal from the voltage regulating generator, and a zener diode connected to a common terminal of the voltage regulating generator supplies a reference voltage. A switching transistor connected to the common terminal of the voltage regulating generator is turned on or off in response to the state of a control voltage supplied through bias resistors and changes the reference voltage. Thus, since the reference voltage is varied dependent on the state of the control voltage, various regulated voltages may be generated from the voltage regulating generator.

For a better understanding of the invention and to show how the same may be carried into effect, reference will now be made, by way of example, to Figures 3 to 8 of the accompanying diagrammatic drawings, in which:

Figure 3 is a diagram of one example of a power source circuit showing an embodiment according to the present invention; and

Figures 4 through 8 are power source circuit diagrams respectively showing other examples of embodiments of the present invention.

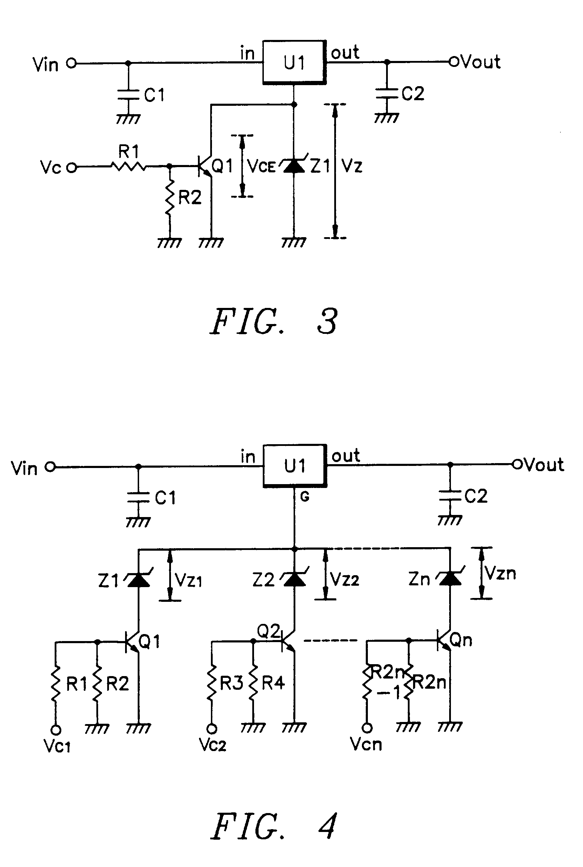

Referring to Figure 3, a first capacitor C1 is connected to attenuate the ripple of an input power source Vin. A voltage regulating generator U1 generates voltage-regulated outputs with respect to the input power source having the attenuated ripple. A second capacitor C2 acts to smooth out the ripple of the signal output from the voltage regulating generator U1, and a zener diode Z1 connected to a common terminal G of the voltage regulating generator U1 supplies a reference voltage thereto. A switching transistor Q1 connected to the common terminal G of the voltage regulating generator U1 is turned on or off in response to the state of a control voltage Vc supplied through bias resistors R1 and R2 and changes the reference voltage. If the control voltage Vc is at a logic low state, the transistor Q1 is turned off. Hence, a voltage $V_A$ across a connecting point of the collector of the transistor Q1, zener diode Z1 and the common terminal G of the voltage regulating generator U1 is equal to a voltage Vz across both terminals of the zener diode Z1. In this case, the input voltage Vin may satisfy the following equation (1):

$$Vin \geq Vu + Vz + Vm \qquad (1)$$

Where Vm is the voltage difference between input and output of the voltage regulating generator U1. Therefore, the output voltage Vout is obtained as follows:

$$Vout = Vu + Vz \qquad (2)$$

Meanwhile, if the control voltage Vc is at a logic high state, since the transistor Q1 is turned on, the voltage $V_A$ becomes $V_A = V_{CE}(sat)$ regardless of the voltage Vz. $V_{CE}(sat)$ is the collector-to-emitter voltage when the transistor Q1 is saturated and its value is about 0.2 volts. Hence, the output voltage Vout can be expressed as follows.

$$Vout = Vu + 0.2V \qquad (3)$$

Thus, since the output voltage Vout is varied dependent on the logic high or low state of the control voltage Vc, the voltage may be selectively produced. Moreover, even if a ripple component is included in the input voltage Vin, the regulated voltage is generated by the voltage regulating generator U1.

In Figure 4, first and second capacitors C1 and C2, voltage regulating generator U1 and zener diode Z1 have the same configuration as those of Figure 3. A switching transistor Q1 for switching a reference voltage is connected to the anode of the zener diode Z1, and a control voltage Vc1 is supplied to the base of the switching transistor Q1 through the bias resistors R1 and R2. Moreover, a plurality of reference voltage sources having a similar configuration to the zener diode Z1, the switching transistor Q1 and bias resistors R1 and R2 are connected to the common terminal G of the voltage regulating generator U1 in parallel. The control voltages Vc1 to Vcn applied to switching transistors Q1 to Qn of reference voltage sources have a first or second state. Let us assume that $V_{CE}(sat)$ is about 0.2 volts and $V_{BE}$ is about 0.6 volts when a switching transistor is turned on. If only one out of the control voltages Vc1 to Vcn is at a logic high state, only the corresponding switching transistor is turned on, and an output voltage Vout obtained by adding a voltage of the zener diode switched by the corresponding transistor with the regulated voltage Vu is generated as indicated in Table 1.

| TABLE 1 | | | | |
|---------|---------|-----|---------|---------|
| Vc1 | Vc2 | ... | Vcn | Vout |
| H | L | ... | L | $Vu + Vz1$ |
| L | H | ... | L | $Vu + Vz2$ |
| . | . | ... | . | . |
| . | . | ... | . | . |
| L | L | ... | H | $Vu + Vzn$ |

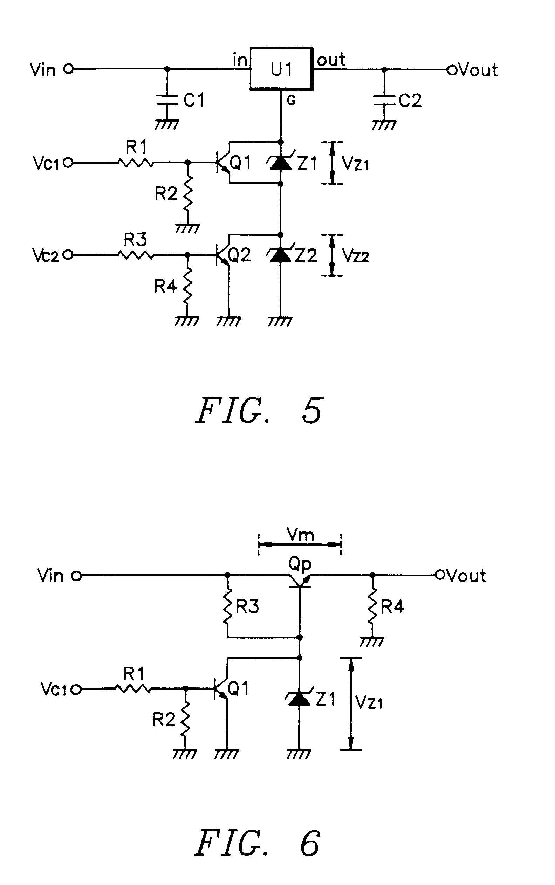

Referring to Figure 5, a first reference voltage source is constructed by connecting a zener diode Z1 between the collector and emitter of a switching transistor Q1. The zener diode Z1 is operated by a first control voltage Vc1 supplied through two bias resistors R1 and R2. Moreover, the first reference voltage source is connected to a common terminal G of a voltage regulating generator U1. First and second capacitors C1 and C2 are connected to input and output terminals of the voltage regulating generator U1, respectively, to remove the ripple. A second reference voltage source having a similar configuration to that of the first reference voltage source is serially connected with the first reference voltage source. If the first and second control voltages Vc1 and Vc2 are both at logic high states, since the transistors Q1 and Q2 are turned on, an output voltage Vout becomes the sum of the collector-to-emitter voltages of the transistors Q1 and Q2 and the regulated voltage Vu. Meanwhile, if the first control voltage Vc1 is at a logic low state and the second control voltage Vc2 is at a logic high state, since only the transistor Q2 is turned on, the output voltage Vout becomes the sum of the regulated voltage Vu, reference voltage Vz1 by the zener diode Z1, and the collector-to-emitter voltage of the transistor Q2. Then, if the first and second control voltages Vc1 and Vc2 are all at logic low states, since the transistors Q1 and Q2 are turned off, the zener diodes Z1 and Z2 maintain their voltages independent of the state of the first and second control voltages Vc1 and Vc2. Therefore, the output voltage Vout is obtained by adding the regulated voltage Vu with the reference voltages Vz1 and Vz2 by the zener diodes Z1 and Z2. This is indicated in Table 2.

TABLE 2

| Vc1 | Vc2 | Vout (V) |
|-----|-----|----------|
| H | H | $Vu + 0.4$ |
| L | H | $Vu + Vz1 + 0.2$ |
| L | L | $Vu + Vz1 + Vz2$ |

Referring to Figure 6, a transistor Qp is connected between input and output power sources Vin and Vout. A resistor R3 is connected between the collector and base of the transistor Qp for providing a bias voltage to the transistor Qp, and a resistor R4 is connected as a load resistor to the emitter of the transistor Qp. The collector of a switching transistor Q1 is commonly connected to the base of the transistor Qp together with the cathode of a zener diode Z1, and a control voltage Vc1 is supplied to the base of the switching transistor Q1 through two bias resistors R1 and R2. The reference voltage is determined by the zener diode Vz1, and the transistor Qp is a control device. The output voltage Vout of the voltage regulating circuit is given by:

$$Vout = Vz1 - V_{BE} \qquad (4)$$

In the equation (4), since zener voltage Vz1 is constant, and in the case of a silicon transistor, the base-to-emitter voltage $V_{BE}$ of the transistor Qp has a constant value of 0.6 to 0.7 volts, the output voltage Vout maintains also a constant value and the circuit is operated as a voltage regulating circuit. The voltage difference Vm of the input and output voltages Vin and Vout constantly maintains the output voltage Vout by incrementing or decrementing the collector-to-emitter voltage of the transistor Qp when the input voltage or load is varied. Therefore, by connecting the switching transistor Q1 to a connecting point of the zener diode Z1 and the transistor Qp, different output voltages can be generated in response to an on or off state of the transistor Qp. If the control voltage Vc1 applied to the base of the transistor Q1 through the bias resistors R1 and R2 is at a logic high state as indicated in Table 3, since the voltage across the transistor Qp is bypassed through the collector and emitter of the transistor Q1, the zener diode Z1 and the transistor Qp may not be operated. Thus, the output voltage Vout is 0 volts. Meanwhile, if the control voltage Vc1 is at a logic low state, since the transistor Q1 is turned off, the zener diode Z1 is normally operated. Moreover, the transistor Qp is turned on, and the output voltage Vout is equal to the value obtained by subtracting the base-to-emitter voltage $V_{BE}$ of the transistor Qp from the reference voltage Vz1 of the zener diode Z1.

TABLE 3

| Vc1 | Vout (V) |
|-----|----------|
| L | Vz1 - 0.6 |
| H | 0 |

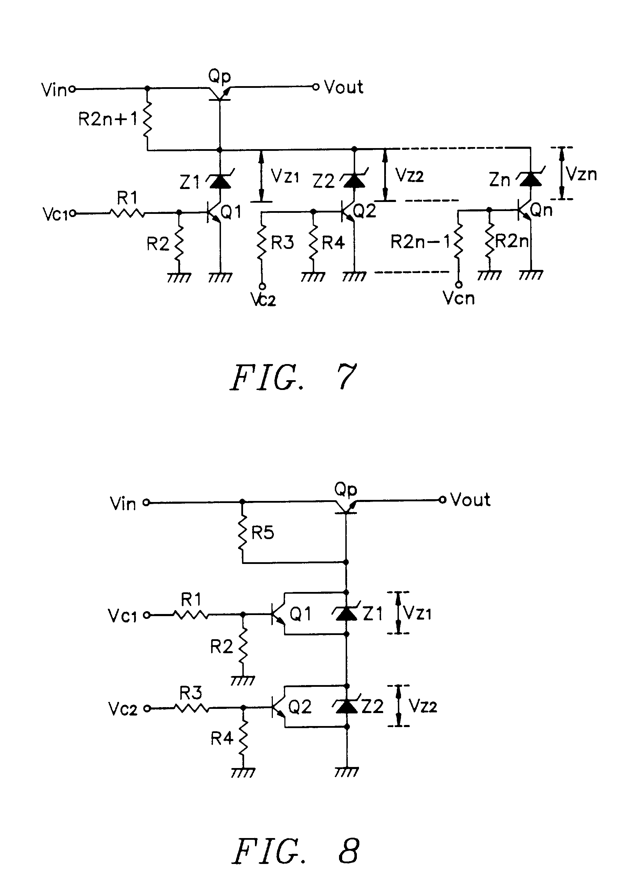

Referring to Figure 7, the cathodes of a plurality of zener diodes Z1 to Zn are respectively connected in parallel to the base of a transistor Qp, the anodes of the zener diodes Z1 to Zn are connected respectively to switching transistors Q1 to Qn, and a resistor R2n+ 1 is connected between the collector and base of a transistor Qp for providing a bias voltage to the transistor Qp. In the circuit, since only a transistor to which a control voltage of a logic high state is supplied is operated, the output voltage Vout is obtained by subtracting the collector-to-emitter voltages of transistors Qp and Qn from the corresponding zener diode voltage. This is represented by Table 4 shown below.

TABLE 4

| Vc1 | Vc2 | ... | Vcn | Vout |
|-----|-----|-----|-----|------|
| H | L | ... | L | Vz1 - 0.4 |
| L | H | ... | L | Vz2 - 0.4 |
| . | . | ... | . | . |
| . | . | ... | . | . |
| L | L | ... | H | Vzn - 0.4 |

Referring to Figure 8, a transistor Qp is connected between input and output power sources Vin and Vout, and a resistor R5 is connected between the collector and base of the transistor Qp for providing a bias voltage to the transistor Qp. First and second zener diodes Z1 and Z2 are serially connected to the base of the transistor Qp, and first and second switching transistors Q1 and Q2 are connected to both terminals of the first and second zener diodes Z1 and Z2, respectively. If two control voltages Vc1 and Vc2 are both at logic high states, since the two transistors Q1 and Q2 are turned on and the voltage across the transistor Qp is bypassed through the collector and emitter of the transistors Q1 and Q2 serially connected to the input power Vin, the output voltage Vout becomes 0 volts. However, if the first control voltage Vc1 is at a logic low state and the second control voltage VC2 is at a logic high state, since only the transistor Q2 is turned on, the output voltage Vout is obtained by subtracting the collector-to-emitter voltage of transistors Qp and Q2 from the reference voltage Vz1 of the zener diode Z1. Then, if both of the first and second control voltages Vc1 and Vc2 are logic low states, since the transistors and Q1 and Q2 are turned off, the output voltage Vout is obtained by subtracting the base-to-emitter voltage of the transistor Qp from the zener voltages of the diodes Z1 and Z2 independent of the transistors Q1 and Q2, as indicated in Table 5.

TABLE 5

| Vc1 | Vc2 | Vout (V) |
|---|---|---|
| H | H | 0 |
| L | H | Vz1 - 0.4 |
| L | L | Vz1 + Vz2 - 0.6 |

As described above, by producing a plurality of voltages by use of a zener diode, a plurality of power sources are not required and there is no necessity to have direct current components without alternating current components before using the power source. Furthermore, by using a voltage regulating generator, even if ripple is included in an input voltage, a regulated voltage is produced. Moreover, the power source output circuit is applicable for a signal transmission technology field using a plurality of power source outputs, in automatic control fields such as speed control of a motor and the like.

**Claims**

1. A variable power source comprising:

   variable voltage regulating means (U1) for generating voltage-regulated outputs;

   reference voltage generating means (Z) connected to said variable voltage regulating means for generating a reference voltage;

   characterised in that the level of the voltage-regulated outputs of the variable voltage regulating means (U1) is variable in response to the reference voltage applied thereto;

   and

   switching means (Q,R) connected to said reference voltage generating means for controlling the level of the reference voltage (Vc) in response to a controlled signal.

2. A circuit as claimed in claim 1, further characterised in that said switching means (Q,R) is an active switching element (Q) responding to said control signal.

3. A circuit as claimed in claim 2, further characterised in that said active switching element comprises a bipolar transistor (Q).

4. A circuit as claimed in claim 2 or 3, further characterised in that bias means provides a bias voltage to said active switching element.

5. A circuit as claimed in any of claims 1 to 4, further characterised in that said reference voltage generating means comprises a zener diode (Z).

6. A circuit as claimed in any of the preceding claims, further characterised in that said switching means (Q) is connected in parallel with said reference voltage generating means (Z).

7. A circuit as claimed in claim 6, characterised in that it further comprises:

   a plurality of said reference voltage generating means (Z) connected in series with each other; and

   a plurality of said switching means (Q) each connected in parallel with a corresponding one of said reference voltage generating means (Z).

8. A circuit as claimed in any of claims 1 to 5, characterised in that it further comprises:

   a plurality of said reference voltage generating means (Z) being connected in parallel to each other; and

a plurality of said switching means (Q) each connected in series with a corresponding one of said reference voltage generating means (Z).

**9.** A circuit as claimed in any of the preceding claims, further characterised in that said variable voltage regulating means (Ul) comprises:

a control transistor (Qp) for generating said voltage-regulated outputs, a base of said control transistor being connected to said reference voltage generating means (Z); and

first resistor means (R3, R2n+1, R5) being connected between a collector and base of said control transistor (Qp), for providing a bias voltage to said control transistor (Qp).

**10.** A circuit as claimed in claim 9, further characterised in that it further comprises second resistor means (R4) being connected as a load resistor to an emitter of said control transistor.


**Patentansprüche**

**1.** Regelbare Spannungsquelle, die umfaßt:

eine Spannungsregeleinrichtung (U1), die spannungsgeregelte Ausgänge erzeugt;

eine Bezugsspannungs-Erzeugungseinrichtung (Z), die mit der Spannungsregeleinrichtung verbunden ist und eine Bezugsspannung erzeugt;

**dadurch gekennzeichnet,** daß sich der Pegel der spannungsgeregelten Ausgänge der Spannungsregeleinrichtung (U1) in Reaktion auf die daran angelegte Bezugsspannung ändert; und

eine Schalteinrichtung (Q,R), die mit der Bezugsspannungs-Erzeugungseinrichtung verbunden ist und den Pegel der Bezugsspannung (Vc) in Reaktion auf ein gesteuertes Signal steuert.

**2.** Schaltung nach Anspruch 1, des weiteren **dadurch gekennzeichnet,** daß die Schalteinrichtung (Q,R) ein aktives Schaltelement (Q) ist, das auf das Steuersignal anspricht.

**3.** Schaltung nach Anspruch 2, des weiteren **dadurch gekennzeichnet,** daß das aktive Schaltelement einen Bipolartransistor (Q) umfaßt.

**4.** Schaltung nach Anspruch 2 oder 3, des weiteren **dadurch gekennzeichnet,** daß eine Vorspannungseinrichtung eine Vorspannung für das aktive Schaltelement erzeugt.

**5.** Schaltung nach einem der Ansprüche 1 bis 4, des weiteren **dadurch gekennzeichnet,** daß die Bezugsspannungs-Erzeugungseinrichtung eine Zener-Diode (Z) umfaßt.

**6.** Schaltung nach einem der vorangehenden Ansprüche, des weiteren **dadurch gekennzeichnet,** daß die Schalteinrichtung (Q) parallel mit der Bezugsspannungs-Erzeugungseinrichtung (Z) verbunden ist.

**7.** Schaltung nach Anspruch 6, **dadurch gekennzeichnet,** daß sie des weiteren umfaßt:

eine Vielzahl der Bezugsspannungs-Erzeugungseinrichtungen (Z), die in Reihe miteinander verbunden sind; und

eine Vielzahl der Schalteinrichtungen (Q), die jeweils parallel mit einer entsprechenden der Bezugsspannungs-Erzeugungseinrichtungen (Z) verbunden sind.

**8.** Schaltung nach einem der Ansprüche 1 bis 5, **dadurch gekennzeichnet,** daß sie des weiteren umfaßt:

eine Vielzahl der Bezugsspannungs-Erzeugungseinrichtungen (Z), die parallel miteinander verbunden sind; und

eine Vielzahl der Schalteinrichtungen (Q), die jeweils in Reihe mit einer entsprechenden der Bezugsspannungs-Erzeugungseinrichtungen (Z) verbunden sind.

9. Schaltung nach einem der vorangehenden Ansprüche, des weiteren **dadurch gekennzeichnet,** daß die Spannungsregeleinrichtung (U1) umfaßt:

einen Steuertransistor (Qp), der die spannungsgeregelten Ausgänge erzeugt, wobei eine Basis des Steuertransistors mit der Bezugsspannungs-Erzeugungseinrichtung (Z) verbunden ist; und

eine erste Widerstandseinrichtung (R1, R2n+1, R5), die zwischen einen Kollektor und eine Basis des Steuertransistors (Qp) geschaltet ist und eine Vorspannung für den Steuertransistor (Qp) erzeugt.

10. Schaltung nach Anspruch 9, des weiteren **dadurch gekennzeichnet,** daß sie weiterhin eine zweite Widerstandseinrichtung (R4) umfaßt, die als ein Lastwiderstand mit einem Emitter des Steuertransistors verbunden ist.


**Revendications**

1. Alimentation variable comprenant :

un moyen de régulation de tension variable (U1) pour produire des sorties régulées en tension ;
un moyen générateur de tension de référence (Z) connecté audit moyen de régulation de tension variable pour produire une tension de référence ;
caractérisé en ce que le niveau des sorties régulées en tension du moyen de régulation de tension variable (U1) est variable en réponse à la tension de référence qui lui est appliquée ; et
en ce qu'un moyen de commutation (Q.R) est connecté audit moyen générateur de tension de référence pour commander le niveau de la tension de référence (Vc) en réponse à un signal commandé.

2. Circuit selon la revendication 1, caractérisé en outre en ce que ledit moyen de commutation (Q.R) est un élément de commutation actif (Q) réagissant audit signal de commande.

3. Circuit selon la revendication 2, caractérisé en outre en ce que ledit élément de commutation actif comprend un transistor bipolaire (Q).

4. Circuit selon la revendication 2 ou 3, caractérisé en outre en ce qu'un moyen de polarisation délivre une tension de polarisation audit élément de commutation actif.

5. Circuit selon l'une quelconque des revendications 1 à 4, caractérisé en outre en ce que ledit moyen générateur de tension de référence comprend une diode de Zener (Z).

6. Circuit selon l'une quelconque des revendications précédentes, caractérisé en outre en ce que ledit moyen de commutation (Q) est connecté en parallèle avec ledit moyen générateur de tension de référence (Z).

7. Circuit selon la revendication 6, caractérisé en ce qu'il comprend en outre :

plusieurs dits moyens générateurs de tension de référence (Z) connectés en série les uns aux autres ; et
plusieurs dits moyens de commutation (Q) chacun connecté en parallèle avec l'un, correspondant, desdits moyens générateurs de tension de référence (Z).

8. Circuit selon l'une quelconque des revendications 1 à 5, caractérisé en ce qu'il comprend en outre :

plusieurs dits moyens générateurs de tension de référence (Z) connectés en parallèle les uns aux autres ; et
plusieurs dits moyens de commutation (Q) chacun connecté en série avec l'un, correspondant, desdits moyens générateurs de tension de référence (Z).

9. Circuit selon l'une quelconque des revendications précédentes, caractérisé en outre en ce que ledit moyen de régulation de tension variable (U1) comprend :

un transistor de commande (Qp) pour produire lesdites sorties régulées en tension, la base dudit transistor de commande étant connectée audit moyen générateur de tension de référence (Z) ; et

un premier moyen résistant (R3, R2n + 1, R5) qui est connecté entre le collecteur et la base dudit transistor de commande (Qp) pour fournir une tension de polarisation audit transistor de commande (Qp).

10. Circuit selon la revendication 9, caractérisé en outre en ce qu'il comprend de plus un second moyen résistant (R4) qui est connecté, en tant que résistance de charge, à l'émetteur dudit transistor de commande.

(PRIOR ART)

*FIG. 1*

(PRIOR ART)

*FIG. 2*

FIG. 3

FIG. 4

FIG. 5

FIG. 6

FIG. 7

FIG. 8

13